# EUROPEAN PATENT SPECIFICATION

(11) **EP 3 730 677 B1**
(45) Date of publication and mention of the grant of the patent: **28.10.2026**
(21) Application number: 18890500.4
(22) Date of filing: 19.09.2018
(51) Int. Cl.: H10D 8/01, H10D 8/60, H10D 48/01, H10D 62/53, H10D 62/83, H10D 64/64, C23C 16/27, C30B 29/04, C30B 25/10, C30B 25/20

(54) **SINGLE CRYSTAL DIAMOND AND SEMICONDUCTOR ELEMENT USING SAME**
EINKRISTALLDIAMANT UND HALBLEITERELEMENT DAMIT
DIAMANT MONOCRISTALLIN ET ÉLÉMENT SEMI-CONDUCTEUR L'UTILISANT

(30) Priority: 20.12.2017 JP 2017243965; 29.06.2018 JP 2018124605
(43) Date of publication of application: 28.10.2020
(73) Proprietor: NATIONAL INSTITUTE OF ADVANCED INDUSTRIAL SCIENCE AND TECHNOLOGY, Chiyoda-ku Tokyo 100-8921 (JP)
(72) Inventor: OHMAGARI Shinya, Ikeda-shi, Osaka 563-8577 (JP); YAMADA Hideaki, Ikeda-shi, Osaka 563-8577 (JP); CHAYAHARA Akiyoshi, Ikeda-shi, Osaka 563-8577 (JP); MOKUNO Yoshiaki, Ikeda-shi, Osaka 563-8577 (JP)
(74) Representative: Mewburn Ellis LLP
(86) International application number: PCT/JP2018/034651
(87) International publication number: WO 2019/123745

(56) References cited:
- EP-A1- 2 276 068
- WO-A1-2014/003110
- JP-A- 2012 176 889
- JP-A- 2013 517 631
- JP-A- 2016 213 409
- JP-A- 2016 213 409
- JP-A- H06 263 594
- JP-A- H06 263 594
- US-A1- 2016 071 936
- OHMAGARI SHINYA ET AL: "Characterization of free-standing single-crystal diamond prepared by hot-filament chemical vapor deposition", DIAMOND AND RELATED MATERIALS, vol. 48, 1 September 2014 (2014-09-01), NL, pages 19 - 23, XP055814270, ISSN: 0925-9635, DOI: 10.1016/j.diamond.2014.06.001
- OHMAGARI S. ET AL: "Low resistivity p+ diamond (100) films fabricated by hot-filament chemical vapor deposition", DIAMOND AND RELATED MATERIALS, vol. 58, 1 September 2015 (2015-09-01), NL, pages 110 - 114, XP055814274, ISSN: 0925-9635, DOI: 10.1016/j.diamond.2015.06.011
- OHMAGARI SHINYA ET AL: "Large reduction of threading dislocations in diamond by hot-filament chemical vapor deposition accompanying W incorporations", APPLIED PHYSICS LETTERS, A I P PUBLISHING LLC, US, vol. 113, no. 3, 19 July 2018 (2018-07-19), XP012230175, ISSN: 0003-6951, [retrieved on 20180719], DOI: 10.1063/1.5040658
- OHMAGARI SHINYA ET AL: "Toward High-Performance Diamond Electronics: Control and Annihilation of Dislocation Propagation by Metal-Assisted Termination", vol. 216, no. 21, 18 September 2019 (2019-09-18), DE, pages 1900498, XP055814376, ISSN: 1862-6300, Retrieved from the Internet <URL:https://onlinelibrary.wiley.com/doi/full-xml/10.1002/pssa.201900498> DOI: 10.1002/pssa.201900498
- WANG W L ET AL: "INTERNAL STRESS AND STRAIN IN HEAVILY BORON-DOPED DIAMOND FILMS GROWN BY MICROWAVE PLASMA AND HOT FILAMENT CHEMICAL VAPOR DEPOSITION", JOURNAL OF APPLIED PHYSICS, AMERICAN INSTITUTE OF PHYSICS, 2 HUNTINGTON QUADRANGLE, MELVILLE, NY 11747, vol. 80, no. 3, 1 August 1996 (1996-08-01), pages 1846 - 1850, XP000632082, ISSN: 0021-8979, DOI: 10.1063/1.362996

## Description

### TECHNICAL FIELD

The present invention relates to a single crystal diamond and a semiconductor element using the same.

### BACKGROUND ART

Conventionally, the methods described in Non-patent documents 1 to 3 are known as a method of lowering the dislocation density of a diamond film.

The method of lowering the dislocation density described in Non-patent document 1 is a method of lowering the dislocation density by increasing a diamond film thickness. It is described that the dislocation density can be lowered from 1 × 10¹⁰ cm⁻² to 4 × 10⁷ cm⁻² by increasing the thickness of a diamond film to 1 mm or more, but the effect becomes smaller as a distance between dislocation lines becomes larger as a result of the lowering the dislocation density, and hence the dislocation density cannot be lowered to a density below 1 × 10⁶ cm⁻².

The method of lowering the dislocation density described in Non-patent document 2 is a method of lowering the dislocation density by forming a pattern, in which a nucleation region is limited, in a pretreatment for heteroepitaxial growth and by controlling a dislocation propagation direction with epitaxial lateral overgrowth (ELO). With this method, the dislocation density can be lowered to about 1 × 10⁸ cm⁻².

The method of lowering the dislocation density described in Non-patent document 3 is a method of lowering the dislocation density by forming metal nanoparticles in an etch pit (location where a dislocation exists) and then by growing a diamond with CVD. Since the formation of the metal nanoparticles is required, it takes time and cost, and it is also a problem to control the dislocation propagation, and it has not been achieved to lower the dislocation below 1 × 10⁶ cm⁻².

Non-patent Document 4 relates to free-standing single-crystal diamond prepared by hot-filament vapor deposition using tungsten filaments. The applied method leads to tungsten atoms being present in the single crystal diamond at a concentration of about 1.8x10¹⁸ cm⁻³. Non-patent document 5 relates to low resistivity p⁺ diamond (100) films fabricated by hot-filament chemical vapor deposition. Non-patent document 6 relates to threading dislocations in diamond made by hot-filament chemical vapor deposition including W incorporations. Non-patent document 7 relates to diamond electronics and the control of dislocation propagation by metal-assisted termination. Patent document 1 relates to impurity-doped diamond having single crystal structure. Patent document 2 relates to diamond crystal films capable of producing a diamond luminescent element. Patent document 3 relates to a method for producing a Schottky diode. Patent document 4 relates to a semiconductor device.

### PRIOR ART DOCUMENTS

### NON-PATENT DOCUMENTS

Non-patent Document 1: C. Stehl, M. Fischer, S. Gsell, E. Berdermann, M.S. Rahman, M. Traeger, O. Klein, and M. Scheck, "Efficiency of dislocation density reduction during heteroepitaxial growth of diamond for detector applications," APPLIED PHYSICS LETTERS 103, 151905 (2013).
Non-patent Document 2: Kimiyoshi Ichikawa, Hideyuki Kodama, Kazuhiro Suzuki, and Atsuhito Sawabe, "Effect of stripe orientation on dislocation propagation in epitaxial lateral overgrowth diamond on Ir," Diamond & Related Materials 72 (2017) 114-118.
Non-patent Document 3: M. Naamoun, A. Tallaire, P. Doppelt, A. Giccquel, J. Barjon, and J. Achard, "Reduction of dislocation densities in single crystal CVD diamond by using self-assembled metallic masks," Diamond & Related Materials 58 (2015) 62-68.
Non-patent Document 4: Ohmagari et al: "Characterization of free-standing single-crystal diamond prepared by hot-filament chemical vapor desposition", Diamond & Related Materials, vol. 48, 1 September 2014, pages 19-23.
Non-patent Document 5: Ohmagari et al: "Low resistivity p+ diamond (100) films fabricated by hot-filament chemical vapor deposition", Diamond & Related Materials, vol. 58, 1 September 2015, pages 110-114.
Non-patent document 6: Ohmagari et al: "Large reduction of threading dislocations in diamond by hot-filament chemical vapor deposition accompanying W incorporations", Applied Physics Letters, vol. 113, no. 3, 19 July 2018.
Non-patent document 7: Ohmagari et al: "Toward High-Performance Diamond Electronics: Control and Annihilation of Dislocation Propagation by Metal-Assisted Termination", Physica Status Solidi. A: Applications and Materials Science, vol. 216, no. 21, 18 September 2019.

### PATENT DOCUMENTS

Patent Document 1: JP 2016213409 A
Patent Document 2: JP H06 263594 A
Patent Document 3: US 2016071936 A1
Patent Document 4: EP 2 276 068 A1

### SUMMARY OF THE INVENTION

### PROBLEMS TO BE SOLVED BY THE INVENTION

The methods described in Non-patent documents 1 to 3 are effective for a sample having a relatively high dislocation density, such as heteroepitaxial diamond, however, the lowering of the dislocation below 1 × 10⁶ cm⁻² is consistently impossible, and the propagation of the dislocations cannot be completely suppressed.

Therefore, according to the embodiments of the present invention, a single crystal diamond having a lowered dislocation density is provided, as set out in the appended claims.

Further, according to the embodiments of the present invention, a semiconductor element using a single crystal diamond having a lowered dislocation density is provided, as set out in the appended claims.

### MEANS FOR SOLVING THE PROBLEM

The present invention provides a single crystal diamond as defined in appended claims 1 to 4, and a semiconductor element as defined in appended claim 5.

### ADVANTAGES OF THE INVENTION

The dislocation density of a single crystal diamond can be lowered.

### BRIEF DESCRIPTION OF THE DRAWINGS

Fig. 1 is a sectional diagram of a single crystal diamond according to an embodiment of the present invention.
Fig. 2 is step diagrams showing a manufacturing method of the single crystal diamond shown in Fig. 1.
Fig. 3 is a sectional diagram of a semiconductor element according to an embodiment of the present invention.
Fig. 4 is a sectional diagram of another semiconductor element according to the embodiment of the present invention.
Fig. 5 is diagrams showing results of measuring the cathodoluminescence of a single crystal diamond in Reference Example 1.
Fig. 6 is a graph showing a distribution of tungsten in the depth direction.
Fig. 7 is a diagram showing a result of measuring the cathodoluminescence of a single crystal diamond in Reference Example 3.
Fig. 8 is diagrams showing results of measuring the cathodoluminescence of a single crystal diamond in Reference Example 4.
Fig. 9 is diagrams showing results of measuring the cathodoluminescence of a single crystal diamond in Example 5.
Fig. 10 is graphs showing current-voltage characteristics at room temperature of semiconductor elements in Reference Example 6 and Comparative Example 2.
Fig. 11 is graphs showing other current-voltage characteristics of semiconductor elements in Reference Example 6 and Comparative Example 2.
Fig. 12 is a graph showing the relationship between a leakage current and an electric field strength at room temperature of a semiconductor element.
Fig. 13 is a graph showing current-voltage characteristics at room temperature of a semiconductor element in Reference Example 7.
Fig. 14 is graphs showing current-voltage characteristics at room temperature of semiconductor elements in Reference Example 8 and Comparative Example 3.
Fig. 15 is a diagram showing ideality factors (n values) of the semiconductor elements in Reference Example 8 and Comparative Example 3.
Fig. 16 is a diagram showing barrier heights of the semiconductor elements in Reference Example 8 and Comparative Example 3.

The reference examples and comparative examples referred to above do not fall within the scope of the claimed invention. Example 5 is instead a working example of the present invention.

### EMBODIMENTS OF THE INVENTION

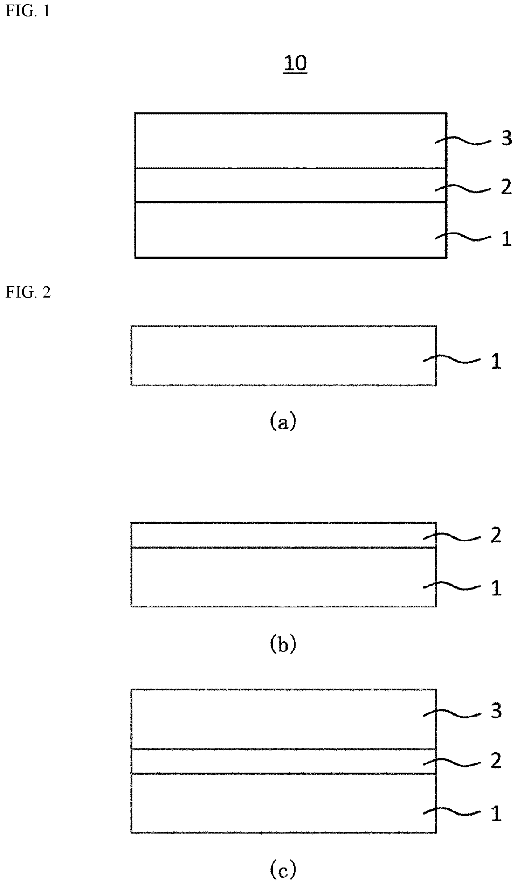

Fig. 1 is a sectional diagram of a single crystal diamond according to an embodiment of the present invention. With reference to Fig. 1, a single crystal diamond 10 according to the embodiment of the present invention includes a single crystal diamond substrate 1 and single crystal diamond layers 2, 3.

The substrate 1 is made of single crystal diamond, also described herein for reference is heteroepitaxial diamond. The single crystal diamond has a dislocation density of, for example, 1 × 10² cm⁻² to 1 × 10⁶ cm⁻², and the heteroepitaxial diamond has a dislocation density of, for example, 1 × 10⁸ to 1 × 10¹⁰ cm⁻². Described herein for reference are substrates 1 made of a substrate in which an individual diamond plates are conjoined laterally (e.g., a grid pattern), so called mosaic wafer or mosaic substrate. Further, in the case of the heteroepitaxial diamond, the substrate may include materials other than diamond, such as iridium (Ir), silicon (Si), silicon carbide (SiC), gallium nitride (GaN), and tungsten carbide (WC), or the substrate may be made of free-standing crystal diamond excluding those heterogeneous substrates.

The single crystal diamond layer 2 is grown on the substrate 1 so as to contact the surface of the substrate 1. The single crystal diamond layer 2 contains tantalum; silicon; and molybdenum. Each of Ta (and, for reference W, Re, Fe, Ni, Co, Al, Ga, Ge, Ir, and P) is an element having a larger atomic radius than carbon (C) and entering between the lattices of a single crystal diamond.

The content of Ta is 1 × 10¹⁶ cm⁻³ to 1 × 10²⁰ cm⁻³. The content of each of Si and Mo is lower than the content of Ta by two orders of magnitude or more. In the single crystal diamond, the content of Ta is limited to 1 × 10²⁰ cm⁻³, and it is not preferable to increase the content of Ta above 1 × 10²⁰ cm⁻³. Ta and Si and Mo produce point defects by being contained in the single crystal diamond layer 2. This point defect is formed between the lattices of the diamond. The point defect density of the single crystal diamond layer 2 is 1 × 10¹⁶ cm⁻³. to 1 × 10²⁰ cm⁻³. The single crystal diamond layer 2 has a thickness of, for example, 1 to 2 µm. Here, the single crystal diamond layer 2 only needs to have a thickness of 1 µm or more. This is because if the thickness is 1 µm or more, the dislocation densities of the single crystal diamond layers 2, 3 can be made lower than the dislocation density of the substrate 1, as described later.

The single crystal diamond layer 2 may contain boron (B) or does not necessarily contain boron (B). If the single crystal diamond layer 2 contains B, the concentration of B is 1 × 10¹⁸ cm⁻³. to 1 × 10²¹ cm⁻³.

The single crystal diamond layer 3 is grown on the single crystal diamond layer 2 so as to contact the single crystal diamond layer 2.

The single crystal diamond layer 3 may or may not contain B. If the single crystal diamond layer 3 contains B, the concentration of B is 1 × 10¹⁵ cm⁻³. to 1 × 10¹⁸ cm⁻³. The thickness of the single crystal diamond layer 3 is not particularly limited, but when the single crystal diamond layer 3 is used for jewelry, the thickness of the single crystal diamond layer 3 should be 200 µm or more.

The single crystal diamond layer 2 has a dislocation density of 2 × 10⁶ cm⁻² or less. The single crystal diamond layer 3 has a dislocation density of, for example, 0 to 1 × 10⁴ cm⁻² (i.e., 1 × 10⁴ cm⁻² or less). As described above, with the single crystal diamond layer 2 containing point defects (i.e., containing Ta; Si; and Mo), the dislocation density of the single crystal diamond layer 3 can be made lower than the substrate 1 by two orders of magnitude or more.

The substrate 1 is made of single crystal diamond, and the single crystal diamond layers 2, 3 are homoepitaxially grown. For reference only, if the substrate 1 is made of Si and the like other than single crystal diamond, the single crystal diamond layers 2, 3 are heteroepitaxially grown.

Fig. 2 is step diagrams showing a manufacturing method of the single crystal diamond 10 shown in Fig. 1. With reference to Fig. 2, the substrate 1 is firstly provided (see step (a)). The substrate 1 is a single crystal diamond having a (100) surface.

Next, the substrate 1 is placed in a vacuum chamber in which filaments are placed, and a carrier gas containing a carbon source is introduced into the vacuum chamber. Then, the single crystal diamond layer 2 is grown on the substrate 1 by a hot filament Chemical Vapor Deposition (CVD) method (see step (b)).

Subsequently, the single crystal diamond layer 3 is grown on the single crystal diamond layer 2 by a CVD method (see step (c)). Thereby, the single crystal diamond 10 is manufactured. As the CVD method, microwave plasma, DC plasma, a combustion method, an arc jet method, and a hot filament method can be used.

When the substrate 1 is made of Si and the like other than single crystal diamond, the single crystal diamond 10 is also manufactured according to the step diagrams shown in Fig. 2.

In the step (b), the single crystal diamond layer 2 may be formed by microwave plasma, DC plasma, a combustion method, an arc jet method, or the like using: any one of a gas containing a carbon source, a gas containing a tungsten source, a gas containing a tantalum source, and a gas containing a rhenium source; a gas containing a silicon source; and a gas containing a molybdenum source.

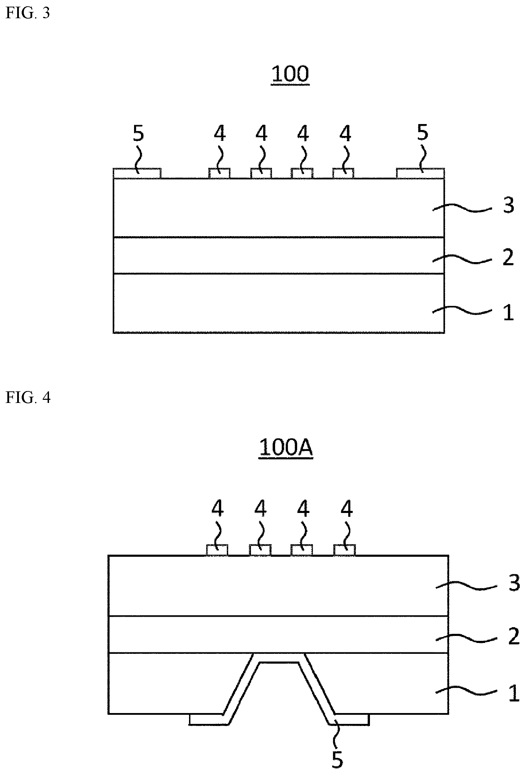

Fig. 3 is a sectional diagram of a semiconductor element according to an embodiment of the present invention. With reference to Fig. 3, a semiconductor element 100 according to the embodiment of the present invention includes the substrate 1, the single crystal diamond layers 2, 3, and electrodes 4, 5. That is, the semiconductor element 100 has a configuration in which the electrodes 4, 5 are added to the single crystal diamond 10 shown in Fig. 1.

The electrodes 4, 5 are disposed on the single crystal diamond layer 3 so as to contact the single crystal diamond layer 3. The electrode 4 is an electrode for Schottky contact, and the electrode 5 is an electrode for ohmic contact.

The electrode 4 is made of, for example, any one of Mo/Au, Ru/Au, Au, Ru, Pt, and Mo, and the electrode 5 is made of, for example, any of Ti/Mo/Au, Ti/Pt/Au, and Ti/Au.

In the semiconductor element 100, the single crystal diamond layer 2 is made of p-type B-doped single crystal diamond film. The concentration of B is, for example, 1 × 10²⁰ cm⁻³. The single crystal diamond layer 3 may or may not be doped with B. When B is doped, the concentration of B is 1 × 10¹⁵ cm⁻³. to 1 × 10¹⁸ cm⁻³.

The semiconductor element 100 is manufactured by, after the single crystal diamond 10 is manufactured according to the step diagrams shown in Fig. 2, forming the electrodes 4, 5 on the single crystal diamond layer 3 with, for example, a chemical vapor deposition method.

Fig. 4 is a sectional diagram of another semiconductor element according to the embodiment of the present invention. The semiconductor element according to the embodiment of the present invention may be a semiconductor element 100A shown in Fig. 4.

With reference to Fig. 4, the semiconductor element 100A has a structure in which part of the substrate 1 is removed by etching and the electrode 5 is formed so as to contact the substrate 1 and the single crystal diamond layer 2. In the semiconductor element 100A, carriers (holes and electrons) move vertically between the electrodes 4, 5, so that a series resistance can be reduced.

The semiconductor element 100A is manufactured by: after the single crystal diamond 10 is manufactured according to the step diagrams shown in Fig. 2, removing part of the substrate 1 by etching; forming the electrodes 4 on the single crystal diamond layer 3 by, for example, a chemical vapor deposition method; and forming the electrode 5 so as to contact the substrate 1 and the single crystal diamond layer 2.

As described above, the single crystal diamond 10 according to the embodiment of the present invention has a structure in which: the single crystal diamond layer 2 having point defects is formed on the substrate 1; and the single crystal diamond layer 3 is formed on the single crystal diamond layer 2.

In the growth of a single crystal diamond, when the substrate 1 has dislocations, the single crystal diamond formed on the substrate 1 grows by inheriting the dislocations of the substrate 1. When the single crystal diamond layer 2 is formed on the substrate 1, however, the point defects in the single crystal diamond layer 2 suppress the propagation (propagation in the thickness direction) of the dislocations which extended from the substrate 1.

As a result, the single crystal diamond layer 2 has a lower dislocation density than the substrate 1. When the single crystal diamond layer 3 is then formed on the single crystal diamond layer 2, the single crystal diamond layer 3 only inherits the dislocations in the single crystal diamond layer 2. As a result, the dislocation densities of the single crystal diamond layers 2, 3 can be made lower than the substrate 1. Therefore, when the single crystal diamond 10 has the structure of substrate 1/single crystal diamond layer 2/single crystal diamond layer 3, the dislocation density of the substrate 1 can be suppressed from propagating to the single crystal diamond layers 2, 3.

The single crystal diamond according to the embodiment of the present invention may be one obtained by removing the single crystal diamond layer 3 from the single crystal diamond 10 shown in Fig. 1. The reason is as follows: the single crystal diamond has the structure of substrate 1/single crystal diamond layer 2, and the dislocations that have propagated from the substrate 1 are suppressed in the middle of the single crystal diamond layer 2 (in the middle in the thickness direction of the single crystal diamond layer 2) from further propagating in the thickness direction of the single crystal diamond layer 2 by the point defects; and hence when the single crystal diamond according to the embodiment of the present invention has the structure of substrate 1/single crystal diamond layer 2, a single crystal diamond having a lower dislocation density than the substrate 1 can be formed.

Hereinafter, the single crystal diamond according to the embodiment of the present invention and a semiconductor element using the same will be described in detail by using examples.

### (REFERENCE EXAMPLE 1)

A CVD substrate was used as the substrate 1. The off-angle of the (100) surface of the CVD substrate was set to 3°.

A hot filament CVD apparatus (Model-650, made by sp3 Diamond Technologies, Inc.) was used for growing the single crystal diamond layer 2. This hot filament CVD apparatus has 19 filaments placed in parallel. The filament material is made from tungsten (W) with a purity of 99.9%, and has a diameter of 0.12 mm and a length of 40 cm. The distance between filaments and the substrate 1 was 15 mm.

The CVD substrate was placed on a sample stage in the hot filament CVD apparatus, and the hot filament CVD chamber was evacuated down to the pressure of 1 Pa.

Then, DC power of 180V × 60A was applied to the hot filaments to raise the temperature of the hot filaments to 2100°C.

Then, 30 sccm of methane (CH₄) gas and 1000 sccm of hydrogen (H₂) gas were introduced into the hot filament CVD apparatus, the pressure was set to 3990 Pa, and the temperature of the substrate was 700°C to 800°C. Thereafter, a single crystal diamond was grown for ten hours, so that the single crystal diamond layer 2 having a thickness of 2 µm was formed on the substrate 1.

After the single crystal diamond layer 2 was formed, the substrate 1/single crystal diamond layer 2 was taken out of the hot filament CVD apparatus, and the substrate 1/single crystal diamond layer 2 was introduced on a sample stage in a 5 kW microwave plasma CVD apparatus made by SEKI DIAMOND SYSTEMS.

Then, the inside of the microwave plasma CVD chamber was evacuated down to the pressure of 5 × 10⁻⁵ Pa.

Subsequently, 20 sccm of methane (CH₄) gas and 480 sccm of hydrogen (H₂) gas were introduced into the microwave plasma CVD apparatus, the pressure was set to 15960 Pa, and the temperature of the substrate was set to 900°C,.

Then, a single crystal diamond was grown on the single crystal diamond layer 2 for one hour by applying a high-frequency power of 2500 W and by a microwave plasma CVD, so that the single crystal diamond layer 3 having a thickness of 4 µm was formed on the single crystal diamond layer 2.

The cathodoluminescence of a single crystal diamond 10-1 in Reference Example 1 was measured. The apparatus used for the measurement is JSM-7001F made by JEOL Ltd. The measurement conditions of cathodoluminescence is acceleration voltage 15 kV, sample temperature 300K, and the center wavelength of a bandpass filter of 430 nm.

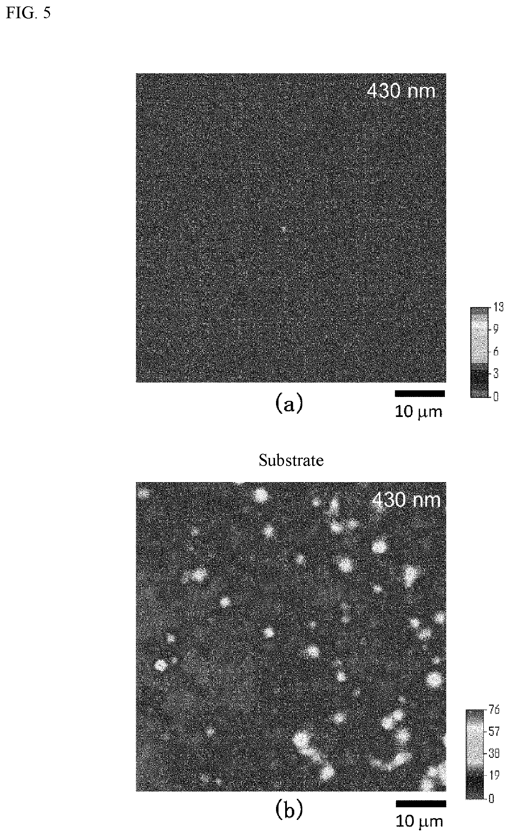

Fig. 5 is diagrams showing results of the cathodoluminescence of the single crystal diamond 10-1 in Reference Example 1. Fig. 5 (a) shows a result of the cathodoluminescence of the single crystal diamond 10-1 in Example 1, and Fig. 5 (b) shows a result of the cathodoluminescence of the diamond substrate (substrate 1).

With reference to Fig. 5, almost no light emission was observed from the single crystal diamond 10-1 in Reference Example 1 (see (a) of Fig. 5). On the other hand, a lot of light emission was observed from the diamond substrate. Then, from the cathodoluminescence measurements, the dislocation density of the single crystal diamond 10-1 in Reference Example 1 was estimated to be 2.6 × 10⁴ cm⁻², and the dislocation density of the diamond substrate was estimated to be 2.1 × 10⁶ cm⁻².

As described above, the dislocation density can be lowered by about two orders of magnitude by adopting the configuration of single crystal diamond layer 2/single crystal diamond layer 3. In the diamond field, researchers are not aware that a dislocation density can be lowered. Therefore, the effect that the dislocation density can be lowered as shown in Reference Example 1 is an effect that cannot be expected by those skilled in the art. Further, the effect that the dislocation density can be lowered from 2.1 × 10⁶ cm⁻² to 2.6 × 10⁴ cm⁻² by two orders of magnitude is an effect that cannot be expected at all by those skilled in the art. As described above, by adopting the configuration of single crystal diamond layer 2/single crystal diamond layer 3, it is possible to enjoy remarkable effects that cannot be expected by those skilled in the art.

Secondary-ion Mass Spectrometry (SIMS) was measured in order to examine the tungsten concentration of the single crystal diamond layer 2. The apparatus used for the SIMS measurement is CAMECA IMS-7f.

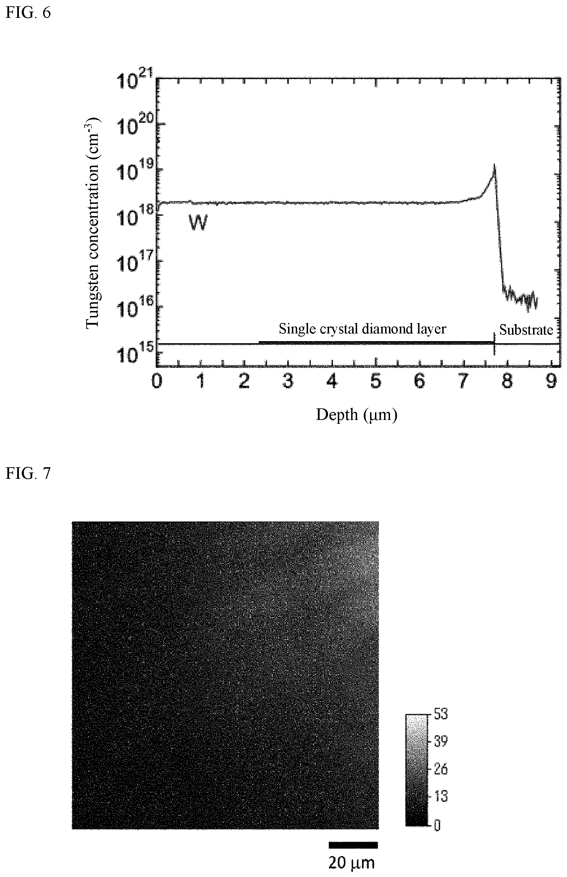

Fig. 6 is a graph showing a distribution of tungsten in the depth direction. In Fig. 6, the vertical axis represents a tungsten concentration, and the horizontal axis represents a distance from the surface in the depth direction. The thickness of the single crystal diamond layer 2 used for the SIMS measurement is 7.5 µm.

With reference to Fig. 6, it was found that tungsten was uniformly distributed in the depth direction at a concentration of about 2 × 10¹⁸ cm⁻³. It was found that when a single crystal diamond was grown by a hot filament CVD method using hot filaments made of tungsten, as described above, tungsten was incorporated into the single crystal diamond. It was also found from the results of the SIMS measurement that the diamond grown by the hot filament CVD method contained 1.4 × 10¹⁶ cm⁻³. of Mo and 1.0 × 10¹⁶ cm⁻³. of Si. As described above, the contents of Si and Mo are lower than that of W by two orders of magnitude or more.

According to the results of the above-described cathodoluminescence and SIMS measurements, it was found that by the single crystal diamond layer 2 containing: any one of tungsten, tantalum, rhenium, iron, nickel, cobalt, aluminum, gallium, germanium, iridium, and phosphorus; molybdenum; and silicon, the dislocation density can be lowered to 2.6 × 10⁴ cm⁻². It is because if it is shown that the dislocation density of the single crystal diamond 10-1 can be lowered by the single crystal diamond layer 2 containing tungsten, molybdenum, and silicon, it can be easily understood that the dislocation density of the single crystal diamond 10-1 can be lowered by the single crystal diamond layer 2 containing: any one of tantalum, rhenium, iron, nickel, cobalt, aluminum, gallium, germanium, iridium, and phosphorus, each of which is an element that has a larger atomic radius than carbon and enters between the lattices of a single crystal diamond, like tungsten; molybdenum; and silicon.

### (COMPARATIVE EXAMPLE 1)

The same CVD substrate as in Reference Example 1 was used as the substrate 1. Then, as Comparative Example 1, a single crystal diamond layer (composed of one single crystal diamond layer) was formed on the substrate 1 by a microwave plasma CVD method under the conditions for forming the single crystal diamond layer 3 in Reference Example 1.

The cathodoluminescence of the formed single crystal diamond layer was measured and the dislocation density was estimated to be 2.1 × 10⁶ cm⁻². Here, the apparatus and measurement conditions used for the cathodoluminescence measurement are the same as in Reference Example 1.

When a single crystal diamond layer is grown by a microwave plasma CVD method, source of tungsten, silicon, and molybdenum are not provided, so the single crystal diamond layer grown by the microwave plasma CVD method does not contain tungsten, silicon, and molybdenum (i.e., point defects). As a result, a dislocation density cannot be lowered below that of the substrate. That is, the propagation of a dislocation density cannot be suppressed. The same applies when any one of tantalum, rhenium, iron, nickel, cobalt, aluminum, gallium, germanium, iridium, and phosphorus is used instead of tungsten.

### (REFERENCE EXAMPLE 2)

A high-temperature and high-pressure substrate (HPHT Ib substrate) having a dislocation density of 1 × 10⁴ cm⁻² was used as the substrate 1. Then, a single crystal diamond layer 2 made of p⁺-type single crystal diamond was formed on the substrate 1 by a hot filament CVD method under the same conditions as the conditions for forming the single crystal diamond layer 2 in Reference Example 1, and then a single crystal diamond layer 3 made of p-type single crystal diamond was formed on the single crystal diamond layer 2 by a hot filament CVD method under the same conditions for forming the single crystal diamond layer 2, whereby a single crystal diamond (substrate 1/single crystal diamond layer 2/single crystal diamond layer 3) was produced.

In this case, 5 sccm of 2% trimethylboron (TMB: B(CH₃)₃) gas diluted with hydrogen was introduced into the hot filament CVD apparatus as a material gas for forming the p-type single crystal diamond. The B concentration of the single crystal diamond layer 2 is 1 × 10²⁰ cm⁻³. Also, 1 sccm of 2% trimethylboron (TMB: B(CH₃)₃) gas diluted with hydrogen was introduced into the hot filament CVD apparatus as a material gas for forming the p-type single crystal diamond. The B concentration of the single crystal diamond layer 3 is 2 × 10¹⁸ cm⁻³.

Then, the cathodoluminescence of each of the single crystal diamond layer 2 and the single crystal diamond layer 3 of a single crystal diamond 10-2 in Reference Example 2 was measured. As a result, the dislocation densities of the single crystal diamond layer 2 and the single crystal diamond layer 3 were 0 cm⁻².

It was found that the dislocation density of the single crystal diamond can be made 0 cm⁻² by forming both the single crystal diamond layer 2 and the single crystal diamond layer 3 by a hot filament CVD method, as described above.

### (REFERENCE EXAMPLE 3)

A single crystal diamond made of substrate 1/single crystal diamond layer 2/single crystal diamond layer 3 was produced in the same way as in Reference Example 1 except that the substrate 1 having a dislocation density of 1.2 × 10⁶ cm⁻² was used.

Fig. 7 is a diagram showing a result of the cathodoluminescence of a single crystal diamond 10-3 in Example 3. The measuring apparatus and the measuring conditions used for the cathodoluminescence measurement are as described in Reference Example 1.

With reference to Fig. 7, no light emission is observed from the single crystal diamond 10-3 in Example 3. Therefore, it was found that the dislocation density of the single crystal diamond 10-3 in Example 3 was 0 cm⁻². The cathodoluminescence was measured for several areas of the single crystal diamond 10-3, but in all the areas no light emission was observed from the single crystal diamond 10-3, and it was confirmed that the dislocation density of the single crystal diamond 10-3 was 0 cm⁻².

### (REFERENCE EXAMPLE 4)

A heteroepitaxial diamond was used as the substrate 1. Then, a single crystal diamond layer 2 made of p-type single crystal diamond was formed on the substrate 1 by using the same hot filament CVD apparatus as in Reference Example 1.

In this case, the temperature of the hot filaments, the substrate temperature, and the pressure in the hot filament CVD apparatus were set to be the same as in Reference Example 1. As material gases, methane (CH₄) gas, hydrogen (H₂) gas, and trimethylboron (TMB: B(CH₃)₃) gas were used, in which the flow rate of the methane (CH₄) gas was 30 sccm and the flow rate of the hydrogen (H₂) gas was 1000 sccm. The film thickness of the p-type single crystal diamond was 3 µm.

The cathodoluminescence of a single crystal diamond 10-4 in Reference Example 4 was measured. The apparatus used for the measurement is the same as the apparatus in Reference Example 1. The conditions for measuring the cathodoluminescence is acceleration voltage 15 kV, sample temperature 80 K, and the center wavelength of a bandpass filter of 430 nm.

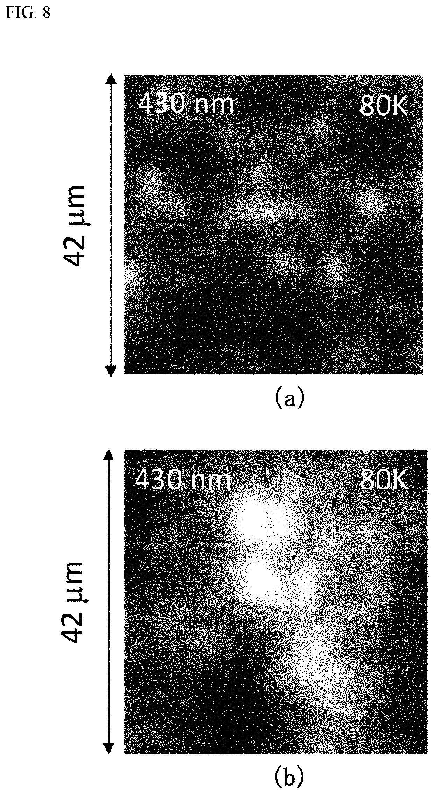

Fig. 8 is diagrams showing results of the cathodoluminescence of the single crystal diamond 10-4 in Reference Example 4. Fig. 8 (a) shows a result of the cathodoluminescence of the single crystal diamond 10-4 in Reference Example 4, and (b) of Fig. 8 shows a result of the cathodoluminescence of the heteroepitaxial diamond which is used for substrate.

With reference to Fig. 8, the light emission from the single crystal diamond 10-4 in Reference Example 4 is less than the light emission from the heteroepitaxial diamond.

Then, as a result of obtaining dislocation densities from the results of measuring the cathode luminescence, the dislocation density of the single crystal diamond 10-4 in Reference Example 4 was 2 × 10⁶ cm⁻², and the dislocation density of the heteroepitaxial diamond was 1 × 10⁸ cm⁻².

As described above, it was found that the dislocation density of the single crystal diamond layer 2 can be lower than the dislocation density of the substrate 1 by about two orders of magnitude by forming the single crystal diamond layer 2 having one layer on the substrate 1.

### (EXAMPLE 5)

The same CVD substrate as in Reference Example 1 was used as the substrate 1. Then, a single crystal diamond layer 2 was formed on the substrate 1 by using hot filaments made of tantalum (Ta) with a purity of 99.9% and under the same conditions as the conditions for forming the single crystal diamond layer 2 in Reference Example 1, whereby substrate 1/single crystal diamond layer 2 was produced.

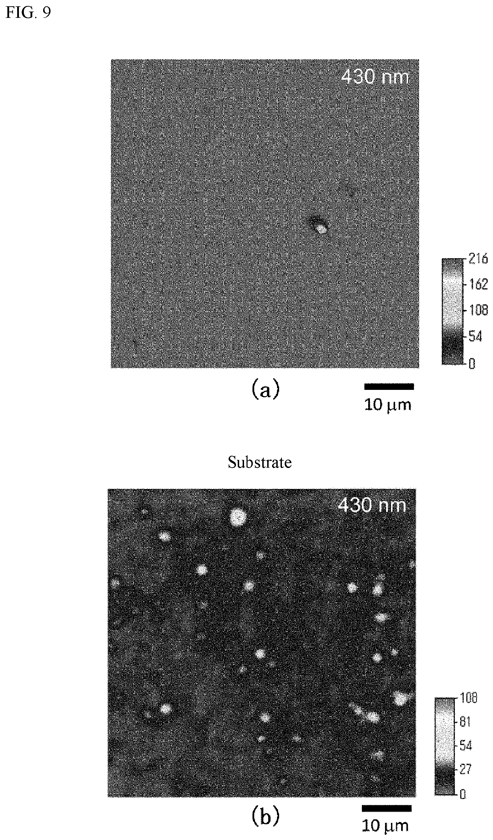

Fig. 9 is diagrams showing results of the cathodoluminescence of the single crystal diamond in Example 5. (a) of Fig. 9 shows a result of the cathode luminescence of a single crystal diamond 10-5 in Example 5, and (b) of Fig. 9 shows a result of the cathodoluminescence of the diamond substrate (substrate 1 made of diamond). Here, the apparatus and measurement conditions used for the cathodoluminescence measurement are the same as in Reference Example 1.

With reference to Fig. 9, almost no light emission is observed from the single crystal diamond 10-5 in Example 5 (see (a) of Fig. 9). On the other hand, much light emission was observed from the diamond substrate.

Then, as a result of obtaining the dislocation densities from the results of measuring the cathodoluminescence, the dislocation density of the single crystal diamond 10-5 in Example 5 was 7.6 × 10⁴ cm⁻², and the dislocation density of the diamond substrate was 2.1 × 10⁶ cm⁻².

As described above, the dislocation density was able to be lowered from 2.1 × 10⁶ cm⁻² to 7.6 × 10⁴ cm⁻² by forming the single crystal diamond layer 2 using hot filaments made of Ta. It is considered that this is because dislocations which propagate from the substrate 1 was suppressed by forming the single crystal diamond layer 2 using hot filaments made of Ta, thereby Ta, Si, and Mo entering the single crystal diamond layer 2 to form point defects. Therefore, it was demonstrated that also when hot filaments made of Ta are used, dislocation propagation from the substrate 1 can be suppressed and the dislocation density of the single crystal diamond layer 2 can be lowered.

As shown in Reference Examples 1-4 and in Example 5, it was found that when the thickness of the single crystal diamond layer 2 is 1 µm or more, the dislocation density can be lowered to the order of 10⁴ cm⁻², and preferably lowered by two orders of magnitude or more.

### (REFERENCE EXAMPLE 6)

The same CVD substrate as in Reference Example 1 was used as the substrate 1. Then, a single crystal diamond layer 2 made of p-type single crystal diamond was formed on the substrate 1 under the same conditions as the conditions for forming the single crystal diamond layer 2 in Reference Example 1, and then a single crystal diamond layer 3 was formed on the single crystal diamond layer 2 in the same way as in Reference Example 1, whereby a single crystal diamond (substrate 1/single crystal diamond layer 2/single crystal diamond layer 3) was produced. In this case, 5 sccm of 2% trimethylboron (TMB: B(CH₃)₃) gas diluted with hydrogen was introduced into the hot filament CVD apparatus as a material gas for forming the p-type single crystal diamond. The B concentration of the single crystal diamond layer 2 is 1 × 10²⁰ cm⁻³.

Then, the surface of the single crystal diamond layer 3 was terminated with hydrogen by using hydrogen plasma by a microwave plasma CVD method under the conditions of 1000°C, 15960 Pa, and 5 minutes.

Then, Ti/Mo/Au was formed on the single crystal diamond layer 3 as ohmic electrodes by an electron-beam (EB) evaporator apparatus. In this case, Ti has a thickness of 10 nm, Mo has a thickness of 10 nm, and Au has a thickness of 30 nm.

After the ohmic electrodes were formed, the surface of the single crystal diamond layer 3 was treated with oxygen plasma. In this case, the substrate temperature is room temperature, the flow rate of oxygen (O₂) gas is 60 sccm, and the pressure is 5 Pa.

After the treatment with oxygen plasma was performed, Mo/Au was formed as Schottky electrodes on the surface of the single crystal diamond layer 3 by a EB evaporator apparatus, whereby a semiconductor element (having the structure shown in Fig. 3) was produced. In this case, Mo has a thickness of 10 nm and Au has a thickness of 30 nm.

### (COMPARATIVE EXAMPLE 2)

The same CVD substrate as in Reference Example 1 was used as the substrate 1. Then, a single crystal diamond layer (composed of one single crystal diamond layer) was formed on the substrate 1 by a microwave plasma CVD method under the same conditions as the conditions for forming the single crystal diamond layer 3 in Reference Example 1.

Thereafter, ohmic electrodes and Schottky electrodes were formed on the single crystal diamond layer in the same way as in Reference Example 6, whereby a semiconductor element (having the structure of substrate/single crystal diamond layer/electrodes) was produced.

The current-voltage characteristics at room temperature of the semiconductor element in Reference Example 6 and the semiconductor element in Comparative Example 2 were measured.

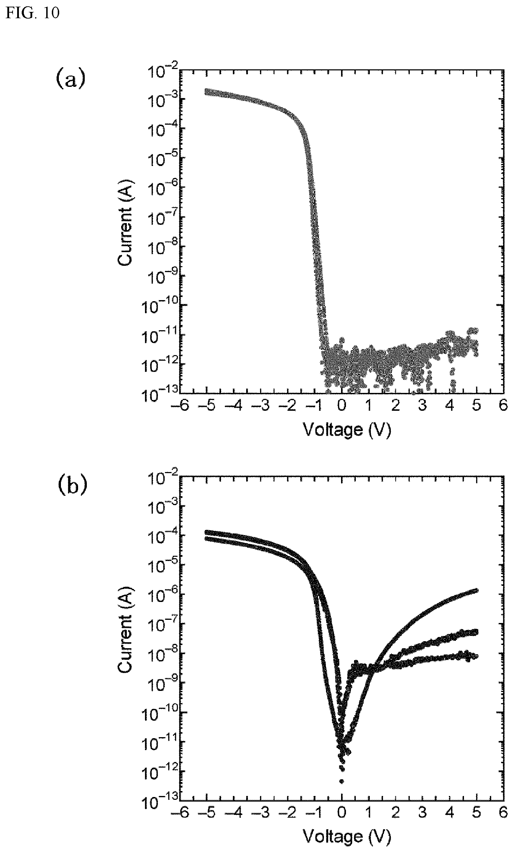

Fig. 10 is graphs showing the current-voltage characteristics at room temperature of the semiconductor elements in Reference Example 6 and Comparative Example 2. In Fig. 10, the vertical axis represents a current and the horizontal axis represents a voltage. Fig. 10 (a) shows the current-voltage characteristics of the semiconductor element in Reference Example 6, and Fig. 10 (b) shows the current-voltage characteristics of the semiconductor element in Comparative Example 2.

With reference to Fig. 10, the semiconductor element in Reference Example 6 exhibits very good rectification characteristics, and the reverse current is lower than 1 × 10⁻¹¹ A (see (a) of Fig. 10).

On the other hand, the semiconductor element in Comparative Example 2 has poor rectification characteristics (see (b) of Fig. 10). In the semiconductor element in Comparative Example 2, the reverse current is 1 × 10⁻⁸ A to 1 × 10⁻⁶ A, which is higher than the reverse current of the semiconductor element in Reference Example 6 by 3 to 5 orders of magnitude.

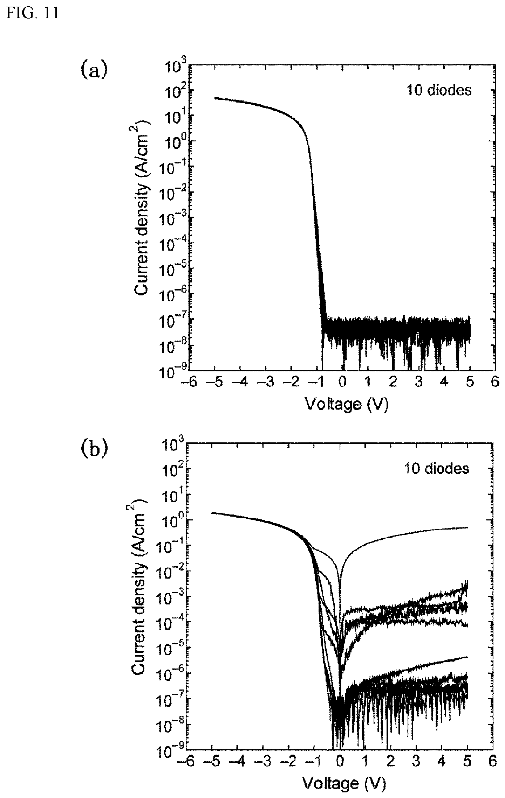

Fig. 11 is graphs showing other current-voltage characteristics of the semiconductor elements in Reference Example 6 and Comparative Example 2. In Fig. 11, the vertical axis represents a current density and the horizontal axis represents a voltage. Fig. 11 (a) shows the current-voltage characteristics of ten semiconductor elements in Reference Example 6, and Fig. 11 (b) shows the current-voltage characteristics of ten semiconductor elements in Comparative Example 2.

With reference to Fig. 11, the semiconductor element in Reference Example 6 exhibits very good rectification characteristics, and the reverse current is about 1 × 10⁻⁷ (A/cm²). Further, the semiconductor element in Reference Example 6 exhibits current-voltage characteristics with good uniformity (see (a) of Fig. 11).

On the other hand, the semiconductor element in Comparative Example 2 has poor rectification characteristics, and the reverse current is in the order of 10⁻⁷ (A/cm²) to 10⁻¹ (A/cm²). Therefore, in the semiconductor element in Comparative Example 2, a variation in the current-voltage characteristics is very large (see (b) of Fig. 11).

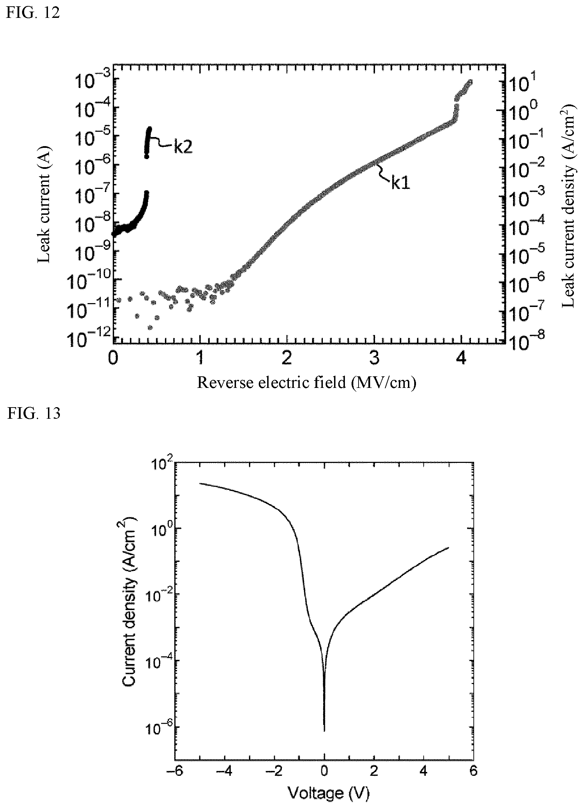

Fig. 12 is a graph showing the relationship between a leakage current and an electric field strength at room temperature of a semiconductor element. In Fig. 12, the vertical axis represents the leak current and the horizontal axis represents the electric field strength. A curve k1 shows the relationship between a leakage current and an electric field strength of the semiconductor element in Reference Example 6, and a curve k2 shows the relationship between a leakage current and an electric field strength of the semiconductor element in Comparative Example 2.

With reference to Fig. 12, the leakage current of the semiconductor element in Reference Example 6 is lower than 1 × 10⁻¹⁰ [A] until the electric field strength becomes 1.4 [MV/cm], and increases as the electric field strength becomes higher than 2 [MV/cm]. The semiconductor element in Reference Example 6 showed breakdown behavior at an electric field strength of about 4.0 [MV/cm] (see the curve k1).

On the other hand, the leakage current of the semiconductor element in Comparative Example 2 is 1 × 10⁻⁸ [A] or lower at the electric field strength below 0.3 [MV/cm]. The semiconductor element in Comparative Example 2 then showed breakdown behavior at an electric field strength of 0.4 [MV/cm] (see the curve k2).

Therefore, the semiconductor element in Reference Example 6 has a lower leakage current and a 10 times or higher breakdown electric field strength than the semiconductor element in Comparative Example 2. It is considered that the reason why a large breakdown electric field strength is obtained as described above is because the dislocation densities of the single crystal diamond layers 2, 3 are lowered.

The current-voltage characteristics of a semiconductor element having a Schottky contact are expressed by the following equation. $I = {I}_{0} \left[exp\left(qV/nkT\right)-1\right]$ (1)

In the equation (1), I is a current, V is a voltage, I₀ is a reverse saturation current, q is an elementary charge, k is the Boltzmann constant, and n is an ideality factor. It shows that the closer n to "1.0" that is an ideal value, the better the current-voltage characteristics are.

The n values were obtained for the semiconductor elements in Reference Example 6 and Comparative Example 2 by fitting the measured current-voltage characteristics into the equation (1). As a result, the n value of the semiconductor element in Reference Example 6 was 1.1, and the n value of the semiconductor element in Comparative Example 2 was 2.7.

Additionally, the barrier heights of the Schottky contacts were obtained for the semiconductor elements in Reference Example 6 and Comparative Example 2. As a result, the barrier height for the semiconductor element in Reference Example 6 was 1.38 eV, and the barrier height for the semiconductor element in Comparative Example 2 was 0.95 eV.

It was found that the semiconductor element in Reference Example 6 had an n value closer to the ideal value and a larger barrier height than the semiconductor element in Comparative Example 2, as described above. It is considered that this is because the dislocation densities of the single crystal diamond layers 2, 3 are lowered as described above.

### (REFERENCE EXAMPLE 7)

A high-temperature and high-pressure substrate (HPHT Ib substrate) having a dislocation density of 1 × 10⁴ cm⁻² was used as the substrate 1. Then, the substrate 1/single crystal diamond layer 2/single crystal diamond layer 3 in Reference Example 2 was produced, and then Ti/Mo/Au was formed on the surface of the single crystal diamond layer 3 as ohmic electrodes and Mo/Au was formed on the surface of the single crystal diamond layer 3 as Schottky electrodes in the same way as in Reference Example 6, whereby a semiconductor element (having the structure shown in Fig. 3) was produced. In this case, the thickness of each of Ti, Mo, and Au in the ohmic electrode and the thickness of each of Mo and Au in the Schottky electrode are as described above.

Fig. 13 is a graph showing the current-voltage characteristics at room temperature of the semiconductor element in Reference Example 7. In Fig. 13, the vertical axis represents a current density and the horizontal axis represents a voltage. With reference to Fig. 13, it was found that the semiconductor element (Schottky element) using the single crystal diamond layer 3 made of p-type single crystal diamond as a drift layer exhibits rectification characteristics. It was demonstrated that the semiconductor element (Schottky element) exhibits rectification characteristics despite the single crystal diamond layer 3 containing B at a concentration of 2.0 × 10¹⁸ cm⁻³, as shown in Reference Example 2. In a conventional semiconductor element (Schottky element), rectification characteristics cannot be obtained if a drift layer contains B at a concentration of the order of 10¹⁸ cm⁻³.

### (REFERENCE EXAMPLE 8)

The same CVD substrate as in Reference Example 1 was used as the substrate 1. Then, a single crystal diamond layer 2 made of p-type single crystal diamond was formed on the substrate 1 by a hot filament CVD method under the same conditions for forming the single crystal diamond layer 2 in Reference Example 1, and then the substrate 1/single crystal diamond layer 2 was taken out of the hot filament CVD apparatus, so that the substrate 1/single crystal diamond layer 2 was placed on a sample stage in a 5 kW microwave plasma CVD apparatus made by SEKI DIAMOND SYSTEMS.

Then, the inside of the microwave plasma CVD chamber was evacuated down to the 5 × 10⁻⁵ Pa.

Subsequently, 20 sccm of methane (CH₄) gas and 480 sccm of hydrogen (H₂) gas were introduced into the microwave plasma CVD apparatus, the pressure in the microwave plasma CVD apparatus was set to 15960 Pa, and the temperature of the substrate was set to 900°C.

Then, a single crystal diamond layer 3 made of p-type single crystal diamond was formed on the single crystal diamond layer 2 for one hour by applying a high-frequency power of 2500 W and by a microwave plasma CVD method.

Thereafter, Ti/Mo/Au was formed on the surface of the single crystal diamond layer 3 as ohmic electrodes and Mo/Au was formed on the surface of the single crystal diamond layer 3 as Schottky electrodes in the same way as in Reference Example 6, whereby a semiconductor element (having the structure shown in Fig. 3) was produced. In this case, the thickness of each of Ti, Mo, and Au in the ohmic electrode and the thickness of each of Mo and Au in the Schottky electrode are as described above.

The single crystal diamond layer 2 made of p-type single crystal diamond has a thickness of 1.4 µm and a B concentration of 2.5 × 10¹⁸ cm⁻³. The single crystal diamond layer 3 made of p-type single crystal diamond has a thickness of 5 µm and a B concentration of 2 × 10¹⁵ cm⁻³.

### (COMPARATIVE EXAMPLE 3)

The same CVD substrate as in Reference Example 1 was used as the substrate 1. Then, a single crystal diamond layer 3 made of p-type single crystal diamond was formed on the substrate 1 under the same conditions as the conditions for forming the single crystal diamond layer 3 in Reference Example 8. The single crystal diamond layer 3 has a thickness of 5 µm and has a B concentration of 2 × 10¹⁵ cm⁻³.

Then, Ti/Mo/Au was formed on the surface of the single crystal diamond layer 3 as ohmic electrodes and Mo/Au was formed on the surface of the single crystal diamond layer 3 as Schottky electrodes in the same way as in Reference Example 6, whereby a semiconductor element was produced. The thicknesses of each of Ti, Mo, and Au in the ohmic electrode and the thicknesses of each of Mo and Au in the Schottky electrode are the same as in Reference Example 8.

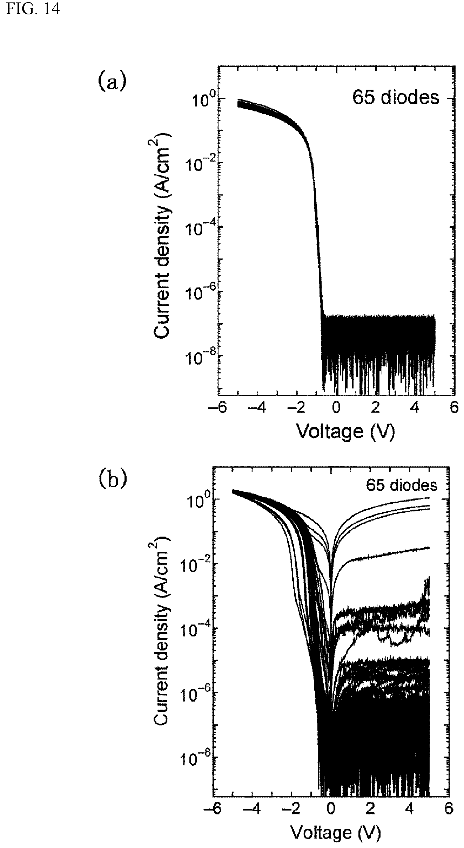

Fig. 14 is graphs showing the current-voltage characteristics at room temperature of the semiconductor elements in Reference Example 8 and Comparative Example 3. In Fig. 14, the vertical axis represents a current density and the horizontal axis represents a voltage. Fig. 14 (a) shows the current-voltage characteristics of the semiconductor element in Reference Example 8, and Fig. 14 (b) shows the current-voltage characteristics of the semiconductor element in Comparative Example 3.

With reference to Fig. 14, the semiconductor element in Reference Example 8 exhibits very good rectification characteristics, and the reverse current is lower than 2 × 10⁻⁷ A (see (a) of Fig. 14). Fig. 14 (a) shows the current-voltage characteristics of 65 semiconductor elements, in which the 65 semiconductor elements in Reference Example 8 exhibit current-voltage characteristics with very good uniformity.

On the other hand, among the semiconductor elements in Comparative Example 3, 23 semiconductor elements exhibit almost the same rectification characteristics as those of the semiconductor elements in Reference Example 8, and 42 semiconductor elements exhibit the reverse saturation current of the order of 10⁻⁷ to 10⁰ (A/cm²) (see (b) of Fig. 14). As described above, the semiconductor element in Comparative Example 3 exhibits current-voltage characteristics with very poor uniformity.

As described above, the semiconductor element in Reference Example 8 exhibits rectification characteristics with very good uniformity, and it is considered that this is because the dislocation density of the single crystal diamond layer 3 is low.

Here, in the current-voltage characteristics of the semiconductor elements in Reference Example 8 and Comparative Example 3 shown in Fig. 14, the forward saturation current densities are at the same level as about 10⁰ (A/cm²), and hence the current-voltage characteristics shown in Fig. 14 show the current-voltage characteristics when a current flows through the single crystal diamond layer 3 in the direction parallel to the substrate 1.

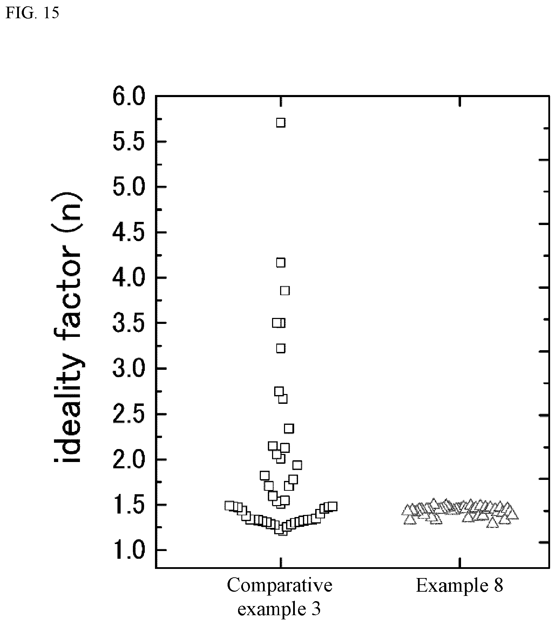

Fig. 15 is a diagram showing the ideality factors (n values) of the semiconductor elements in Reference Example 8 and Comparative Example 3. With reference to Fig. 15, the semiconductor element in Reference Example 8 has an n value in the range of 1.29 to 1.50, and the semiconductor element in Comparative Example 3 has an n value in the range of 1.21 to 5.71.

As described above, the n values of the semiconductor elements in Reference Example 8 show a distribution with good uniformity, and the n values of the semiconductor elements in Comparative Example 3 show a distribution with large variation.

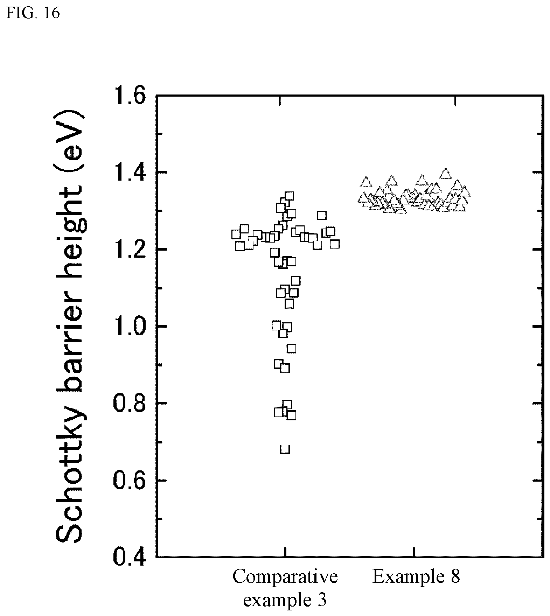

Fig. 16 is a diagram showing barrier heights of the semiconductor elements in Reference Example 8 and Comparative Example 3. With reference to Fig. 16, the semiconductor element in Reference Example 8 has a barrier height in the range of 1.30 to 1.39, and the semiconductor element in Comparative Example 3 has a barrier height of 0.68 to 1.34.

As described above, the barrier heights of the semiconductor elements in Reference Example 8 also exhibit a distribution with good uniformity, and the barrier heights of the semiconductor elements in Comparative Example 3 also exhibit a distribution with large variation.

In the semiconductor element (Schottky element) in which a current flows through the single crystal diamond layer 3 in the direction parallel to the substrate 1, it was found that the uniformity of current-voltage characteristics is dramatically improved by adopting the configuration of single crystal diamond layer 2/single crystal diamond layer 3, as described above. This is because the semiconductor element in Reference Example 8 has an n value and a barrier height with good uniformity.

### INDUSTRIAL APPLICABILITY

The present invention can be applied to single crystal diamonds and semiconductor elements using the same.

### DESCRIPTION OF REFERENCE SIGNS

1: Substrate
2, 3: Single crystal diamond layer
4, 5: Electrode
10: Single crystal diamond
100, 100A : Semiconductor element.

## Claims

1. A single crystal diamond (10) comprising a first single crystal diamond layer (2) formed on a single crystal diamond substrate (1), wherein
the first single crystal diamond layer (2) has a thickness of at least 1 µm,
the first single crystal diamond layer (2) has a lower dislocation density than the single crystal diamond substrate (1),
the first single crystal diamond layer (2) contains tantalum, silicon, and molybdenum, producing point defects with a point defect density of 1 × 10¹⁶ cm⁻³. to 1 × 10²⁰ cm⁻³, and
wherein the point defects in the first single crystal diamond layer (2) suppress propagation in a thickness direction of dislocations which extend from the single crystal diamond substrate (1).

2. The single crystal diamond (10) according to claim 1, further comprising a second single crystal diamond layer (3) grown on the first single crystal diamond layer (2) and having a lower dislocation density than the single crystal diamond substrate (1).

3. The single crystal diamond (10) according to claim 2, wherein the second single crystal diamond layer (3) has a film thickness of 200 µm or more.

4. The single crystal diamond (10) according to claim 2, wherein the first single crystal diamond layer (2) further contains a p-type dopant.

5. A semiconductor element comprising:
the single crystal diamond (10) according to claim 4;
a first metal that forms a Schottky contact with the second single crystal diamond layer (3); and
a second metal that forms an ohmic contact with the first single crystal diamond layer (2) or the second single crystal diamond layer (3).

## Patentansprüche

1. Einkristalldiamant (10), umfassend eine erste Einkristalldiamantschicht (2), die auf einem Einkristalldiamantsubstrat (1) ausgebildet ist, wobei
die erste Einkristalldiamantschicht (2) eine Dicke von zumindest 1 µm aufweist,
die erste Einkristalldiamantschicht (2) eine niedrigere Versetzungsdichte als das Einkristalldiamantsubstrat (1) aufweist,
die erste Einkristalldiamantschicht (2) Tantal, Silizium und Molybdän enthält, die Punktdefekte mit einer Punktdefektdichte von 1 × 10¹⁶ cm⁻³ bis 1 × 10²⁰ cm⁻³ hervorrufen, und
wobei die Punktdefekte in der ersten Einkristalldiamantschicht (2) die Ausbreitung von Versetzungen, die sich vom Einkristalldiamantsubstrat (1) weg erstrecken, in Dickenrichtung unterdrücken.

2. Einkristalldiamant (10) nach Anspruch 1, ferner umfassend eine zweite Einkristalldiamantschicht (3), die auf der ersten Einkristalldiamantschicht (2) gezüchtet wurde und eine niedrigere Versetzungsdichte als das Einkristalldiamantsubstrat (1) aufweist.

3. Einkristalldiamant (10) nach Anspruch 2, wobei die zweite Einkristalldiamantschicht (3) eine Filmdicke von 200 µm oder mehr aufweist.

4. Einkristalldiamant (10) nach Anspruch 2, wobei die erste Einkristalldiamantschicht (2) ferner ein Dotierungsmittel vom p-Typ enthält.

5. Halbleiterelement, umfassend:
einen Einkristalldiamanten (10) nach Anspruch 4:
ein erstes Metall, das einen Schottky-Kontakt mit der zweiten Einkristalldiamantschicht (3) ausbildet; und
ein zweites Metall, das einen Ohmschen Kontakt mit der ersten Einkristalldiamantschicht (2) oder der zweiten Einkristalldiamantschicht (3) ausbildet.

## Revendications

1. Diamant monocristallin (10) comprenant une première couche de diamant monocristallin (2) formée sur un substrat de diamant monocristallin (1), dans lequel
la première couche de diamant monocristallin (2) présente une épaisseur d'au moins 1 µm,
la première couche de diamant monocristallin (2) présente une densité de dislocation inférieure à celle du substrat de diamant monocristallin (1),
la première couche de diamant monocristallin (2) contient du tantale, du silicium et du molybdène, produisant des défauts ponctuels avec une densité de défauts ponctuels de 1 × 10¹⁶ cm⁻³ à 1 × 10²⁰ cm⁻³, et
dans lequel les défauts ponctuels dans la première couche de diamant monocristallin (2) suppriment la propagation dans une direction d'épaisseur de dislocations qui s'étendent à partir du substrat de diamant monocristallin (1).

2. Diamant monocristallin (10) selon la revendication 1, comprenant en outre une seconde couche de diamant monocristallin (3) mise à croître sur la première couche de diamant monocristallin (2) et présentant une densité de dislocation inférieure à celle du substrat de diamant monocristallin (1).

3. Diamant monocristallin (10) selon la revendication 2, dans lequel la seconde couche de diamant monocristallin (3) présente une épaisseur de film de 200 µm ou plus.

4. Diamant monocristallin (10) selon la revendication 2, dans lequel la première couche de diamant monocristallin (2) contient en outre un dopant de type p.

5. Élément semi-conducteur, comprenant :
le diamant monocristallin (10) selon la revendication 4 ;
un premier métal qui forme un contact Schottky avec la seconde couche de diamant monocristallin (3) ; et
un second métal qui forme un contact ohmique avec la première couche de diamant monocristallin (2) ou la seconde couche de diamant monocristallin (3).
